Europäisches Patentamt

European Patent Office

Office européen des brevets

(11) Publication number: **0 488 382 A2**

# EUROPEAN PATENT APPLICATION

(21) Application number: **91120558.1**

(22) Date of filing: **29.11.91**

(51) Int. Cl.5: **H03K 3/037**

(30) Priority: **30.11.90 JP 336071/90**

(43) Date of publication of application:
**03.06.92 Bulletin 92/23**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**
Applicant: **TOSHIBA MICRO-ELECTRONICS**
**CORPORATION**
**25-1, Ekimaehoncho**
**Kawasaki-ku Kawasaki-shi(JP)**

(72) Inventor: **Sano, Yoshiyuki**
**102, Heights Kobayashi, 2-3-23, Mutsuura**
**Kanazawa-ku, Yokohama-shi,**
**Kanagawa-ken(JP)**

(74) Representative: **Lehn, Werner, Dipl.-Ing. et al**
**Hoffmann, Eitle & Partner Patentanwälte**
**Arabellastrasse 4 Postfach 81 04 20**
**W-8000 München 81(DE)**

(54) **Latch circuit.**

(57) A latch circuit including: a first input terminal (IN201) to which a first signal to be latched is inputted; a second input terminal (IN202) to which is inputted a second signal which controls an operation of latching the first signal or an operation of resetting a latch state; an input logic circuit (203) whose input terminals are connected to the first and second input terminals (IN201, IN202); an R-S latch circuit (204) whose one input terminal is connected to the output terminal of the input logic circuit (203) and whose other input terminal is connected to the second input terminal (IN202); an output logic circuit (205) whose input terminals are connected to one of two output terminals of the R-S latch circuit (204) and to the second input terminal (IN202); and an output terminal (OUT20) connected to the output terminal of the output logic circuit (205), for holding an output signal of a predetermined level during the latch state.

FIG.I

EP 0 488 382 A2

BACKGROUND OF THE INVENTION

The present invention relates to a latch circuit suitable particularly for over-current protection.

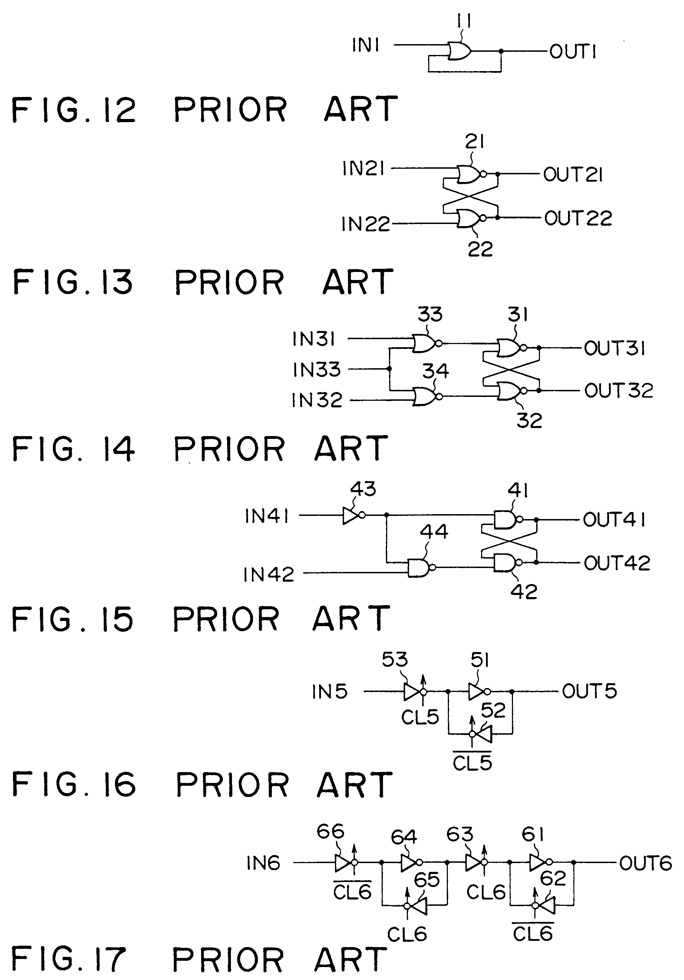

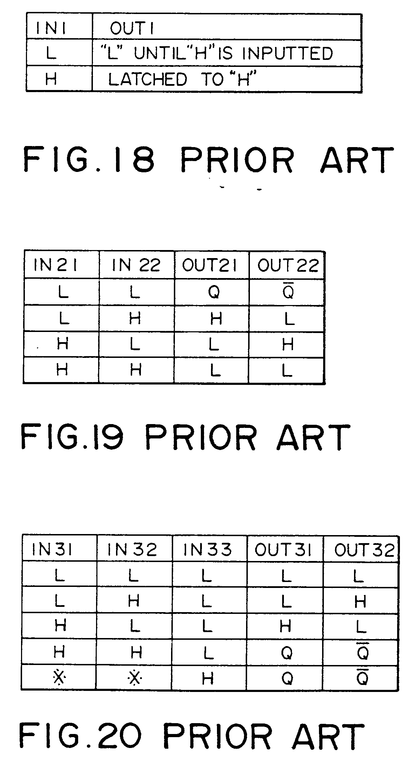

There is known a conventional latch circuit such as shown in Fig. 12. A signal is inputted to one IN1 of two input terminals of a NOR circuit 11. The other input terminal is connected to an output terminal OUT1. This circuit operates in the manner shown in a truth table of Fig. 18. So long as a low level signal is inputted to the input terminal IN1, a low level signal is outputted from the output terminal OUT1. If a high level signal is once inputted, the output signal is latched to the high level.

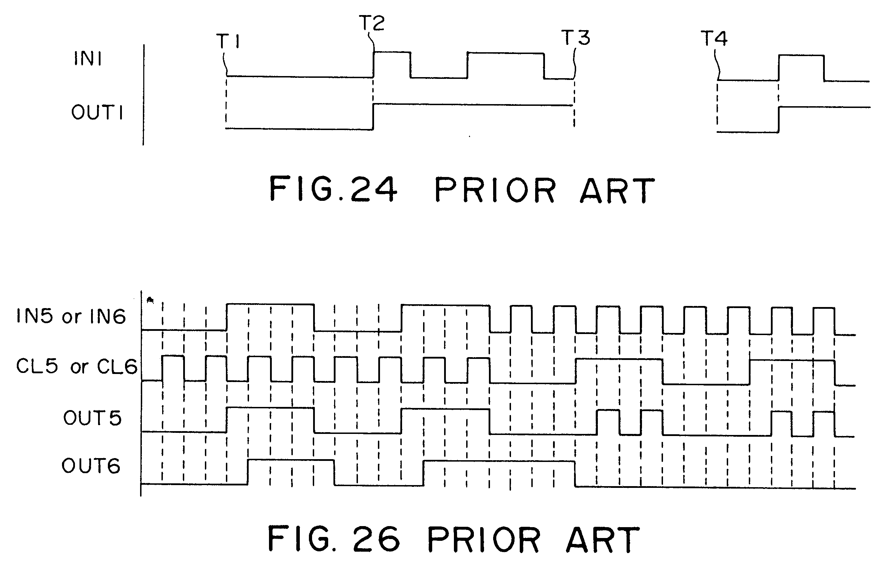

The level changes at the input terminal IN1 and output terminal OUT1 of this circuit are shown in Fig. 24. The circuit starts operating upon power-on at time T1. When the level at the input terminal IN1 becomes high level at time T2, the output terminal OUT1 is latched to the high level. The level at the output terminal OUT1 will not change until the power is turned off at time T3. If the power is turned on again at time T4 and the level at the input terminal IN1 is low level, then the output terminal OUT1 recovers the low level.

This latch circuit is however associated with the problem that if a high level signal such as noise is erroneously inputted to the input terminal IN1, the circuit cannot be reset unless the power is turned off. Such a phenomenon is likely to occur particularly at the time of power-on.

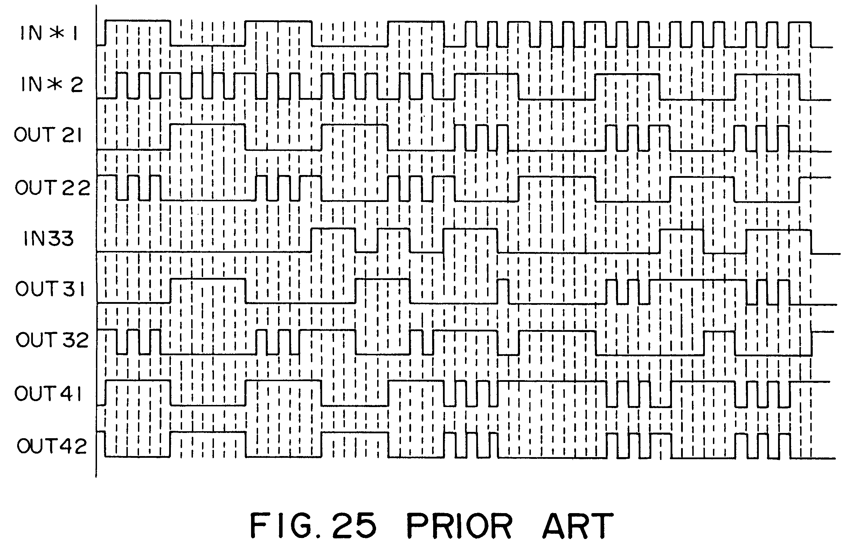

There are also known conventional latch circuits such as shown in Figs. 13 to 17. The circuit shown in Fig. 13 is a general R-S NOR latch circuit comprised by two NOR circuits 21 and 22. The levels at two input terminals IN21 and IN22 and two output terminals OUT21 and OUT22 change in the manner shown in the truth table of Fig. 19 and the timing chart of Fig. 25. "Q" and "$\overline{Q}$" shown in Fig. 19 indicate that the held data is outputted. Input terminals IN*1 and IN*2 shown in Fig. 25 represent collectively for all input terminals IN21 to 41 and IN22 to 42 of the circuits shown in Figs. 13 to 15.

The circuit shown in Fig. 14 is an R-S NOR latch circuit with a gate. To one of the two input terminals of an R-S NOR latch circuit comprised by NOR circuits 31 and 32, there is connected an output terminal of a NOR circuit 33 having two input terminals IN31 and IN33. To the other input terminal of the R-S NOR latch, there is connected an output terminal of a NOR circuit 34 having two input terminals IN32 and IN33. This circuit operates in the manner shown in the truth table of Fig. 20 and the timing chart of Fig. 25. The input terminal IN33 corresponds to the gate. While the gate is low level, the input signal is supplied to the R-S NOR latch circuit. When the gate takes a high level, the circuit enters a latch state.

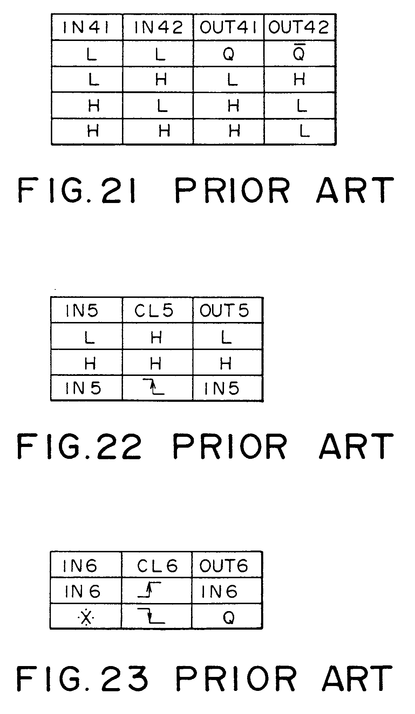

The latch circuit shown in Fig. 15 is constructed of an R-S NAND latch circuit comprised by NAND circuits 41 and 42, and an inverter 43 and a NAND circuit 44 added to the R-S NAND latch circuit. The levels at output terminals OUT41 and OUT42 of the latch circuit change in the manner shown in the truth table of Fig. 21 and the timing chart of Fig. 25.

The circuit shown in Fig. 16 is a D-type latch circuit which is constructed of a clocked inverter 53 operating upon reception of a high level clock CL5, another clocked inverter 52 operating upon reception of a low level clock $\overline{CL5}$, and an inverter 51. An input terminal IN5 is connected to the input terminal of the clocked inverter 53. The input terminal of the clocked inverter 53 is connected to the input terminal of the inverter 51 and to the output terminal of the clocked inverter 52. The output terminal of the inverter 51 and the input terminal of the clocked inverter 52 are commonly connected to the output terminal OUT5.

The level at the output terminal OUT5 of this D-type latch circuit changes in the manner shown in the truth table of Fig. 22, in accordance with the level at the input terminal IN5. The level at the input terminal IN5 is latched and outputted from the output terminal OUT5, when the clock $\overline{CL5}$ inputted to the clocked inverter 52 rises. An "arrow" shown in Fig. 22 indicates a signal rise or signal fall, and an "IN5" indicates that the level at the input terminal itself appears at the output terminal OUT5. The level at the input terminal IN5, the level of the clock CL5, and the level at the output terminal OUT5 change in the manner shown in the timing chart of Fig. 26.

The latch circuit shown in Fig. 17 is a master-slave flip-flop which is constructed of a D-type latch comprised by clocked inverters 65 and 66 and an inverter 64, and a serially connected D-type latch comprised by clocked inverters 62 and 63 and an inverter 61. The latch circuit shown in Fig. 16 has the following problem. Namely, as shown in the timing chart of Fig. 25, when the level at the input terminal IN5 changes while the clock CL5 is high level, the level at the output terminal OUT5 changes even if the clock CL5 does not change its level. The circuit shown in Fig. 17 solves such a problem. In this master-slave flip-flop, only when the level at the input terminal IN6 changes at the rise timing of the clock CL6, the level at the output terminal OUT6 changes.

Different from the latch circuit shown in Fig. 12, the latch circuits shown in Figs. 13 to 17 can be reset by an additional input signal even if it once enters a latch state by an erroneous signal.

However, these latch circuits require an additional input signal and clock signals in addition to a latch input signal. If the function of the latch circuit shown in Fig. 12 is to be maintained, in addition to a latch input signal, there are required to provide a corresponding additional input signal and clock signals. Therefore, new circuits must be provided to the latch circuits shown in Figs. 13 to 17, resulting in an increased number of circuit elements.

In summary, the conventional latch circuit shown in Fig. 12 has the problem that if an erroneous signal is inputted, it cannot be reset until the power is turned off. The conventional latch circuits shown in Figs. 13 to 17 have the problem of an increased number of circuit elements.

## SUMMARY OF THE INVENTION

It is therefore an object of the present invention to provide a latch circuit capable of being reset without turning off power when the circuit is latched by an erroneous signal, and capable of providing the latch function illustrated with Fig. 12 with a minimum number of circuit elements.

According to the present invention, there is provided a latch circuit comprising: a first input terminal to which a first signal to be latched is inputted; a second input terminal to which is inputted a second signal which controls an operation of latching the first signal or an operation of resetting a latch state; an input logic circuit whose input terminals are connected to the first and second input terminals; an R-S latch circuit whose one input terminal is connected to the output terminal of the input logic circuit and whose other input terminal is connected to the second input terminal; an output logic circuit whose input terminals are connected to one of two output terminals of the R-S latch circuit and to the second input terminal; and an output terminal connected to the output terminal of the output logic circuit, for holding an output signal of a predetermined level during the latch state.

The first and second signals are inputted to the input logic circuit. The output of the input logic circuit is supplied to one input terminal of the R-S latch circuit, and the second signal is supplied to the other input terminal. One of the two outputs from the R-S latch circuit and the second signal are supplied to the output logic circuit. The output of the output logic circuit is derived from the output terminal of the latch circuit. When the second signal takes a predetermined level, the latch circuit is set to an initial state for monitoring the level change of the first signal. When the first signal changes to a predetermined level, the circuit enters a latch state to hold the output signal level. This latch state is reset when the second signal changes its level. Thus, the output signal level changes with the level of the first signal. According to this latch circuit, even if an erroneous first input signal such as noises are applied and the circuit enters the latch state, the circuit can be easily reset by changing the level of the second signal without turning off the power. The second signal is sufficient if it changes its level only for controlling the latch and reset operations. Therefore, no new circuit elements are required while ensuring a reliable latch operation without increasing the number of circuit elements.

## BRIEF DESCRIPTION OF THE DRAWINGS

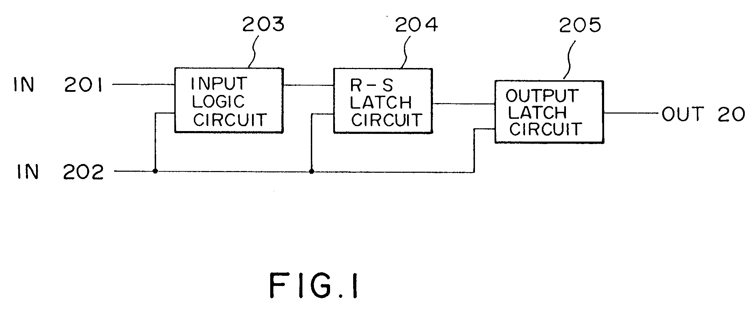

Fig. 1 is a block diagram showing the structure of a latch circuit according to an embodiment of the present invention;

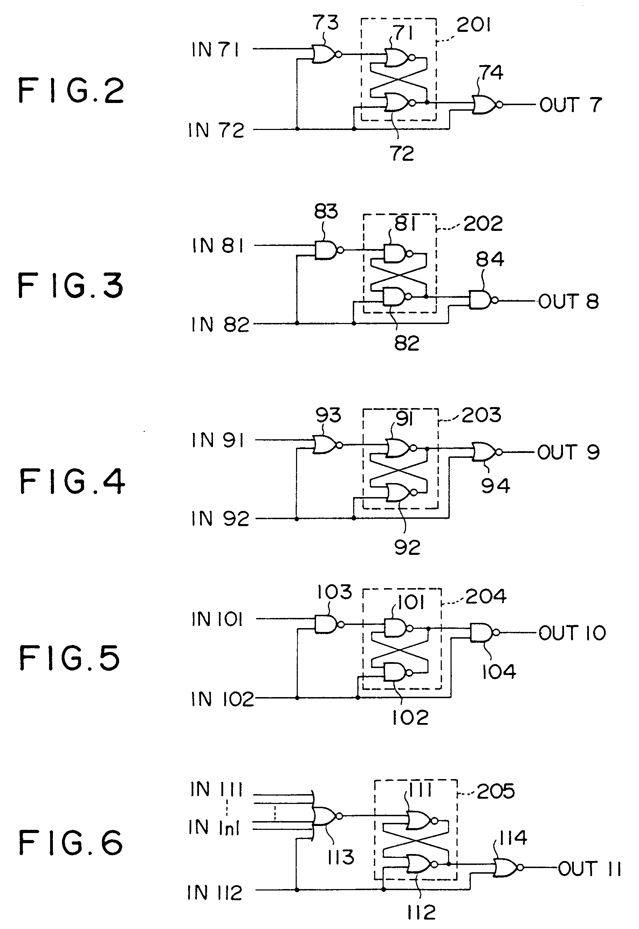

Fig. 2 is a circuit diagram showing the structure of a latch circuit according to a first embodiment of the present invention;

Fig. 3 is a circuit diagram showing the structure of a latch circuit according to a second embodiment of the present invention;

Fig. 4 is a circuit diagram showing the structure of a latch circuit according to a third embodiment of the present invention;

Fig. 5 is a circuit diagram showing the structure of a latch circuit according to a fourth embodiment of the present invention;

Fig. 6 is a circuit diagram showing the structure of a latch circuit according to a fifth embodiment of the present invention;

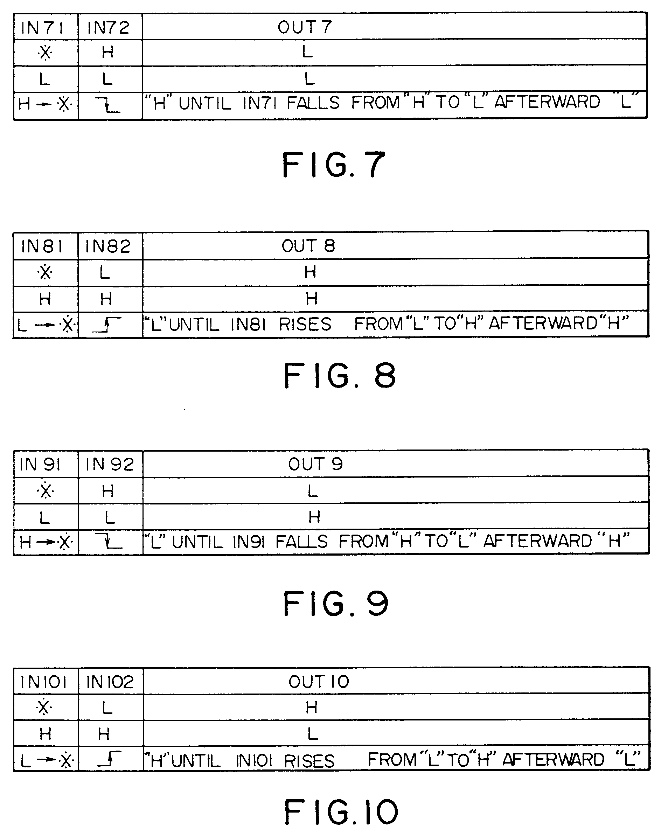

Fig. 7 is a truth table of the latch circuit according to the first embodiment of the present invention;

Fig. 8 is a truth table of the latch circuit according to the second embodiment of the present invention;

Fig. 9 is a truth table of the latch circuit according to the third embodiment of the present invention;

Fig. 10 is a truth table of the latch circuit according to the fourth embodiment of the present invention;

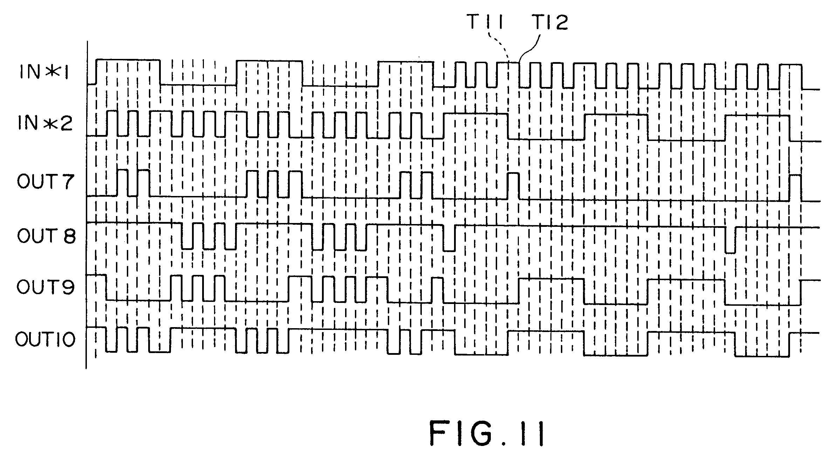

Fig. 11 is a timing chart showing the level changes at input and output terminals of the latch circuits according to the first to fourth embodiments of the present invention;

Fig. 12 is a circuit diagram showing the structure of a conventional latch circuit;

Fig. 13 is a circuit diagram showing the structure of another conventional latch circuit;

Fig. 14 is a circuit diagram showing the structure of another conventional latch circuit;

Fig. 15 is a circuit diagram showing the structure of another conventional latch circuit;

Fig. 16 is a circuit diagram showing the structure of another conventional latch circuit;

Fig. 17 is a circuit diagram showing the structure of another conventional latch circuit;

Fig. 18 is a truth table for the latch circuit shown in Fig. 12;

Fig. 19 is a truth table for the latch circuit shown in Fig. 13;

Fig. 20 is a truth table for the latch circuit shown in Fig. 14;

Fig. 21 is a truth table for the latch circuit shown in Fig. 15;

Fig. 22 is a truth table for the latch circuit shown in Fig. 16;

Fig. 23 is a truth table for the latch circuit shown in Fig. 17;

Fig. 24 is a timing chart showing the level changes at input and output terminals of the latch circuit shown in Fig. 12;

Fig. 25 is a timing chart showing the level changes at input and output terminals of the latch circuits shown in Figs. 13 to 15; and

Fig. 26 is a timing chart showing the level changes at input and output terminals of the latch circuits shown in Figs. 16 and 17.

DESCRIPTION OF THE PREFERRED EMBODIMENTS

Embodiments of the present invention will be described with reference to the accompanying drawings.

Fig. 1 shows the constitutional circuit elements and connection therebetween of a latch circuit according to an embodiment of the present invention. There are provided two input terminals IN201 and IN202. To the input terminal IN201, there is inputted a signal to be latched. To the input terminal IN202, there is inputted a signal for latching the signal inputted to the input terminal IN201 or resetting a latch state. The input terminals IN201 and IN202 are connected to the input terminals of an input logic circuit 203. The output terminal of the input logic circuit 203 and the input terminal IN202 are connected to the input terminals of an R-S latch circuit 204. The output terminal of the R-S latch circuit 204 and the input terminal IN202 are connected to the input terminals of an output logic circuit 205. The output terminal of the output logic circuit 205 is connected to an output terminal OUT20.

Next, the embodiments of the present invention will be described wherein particular input logic circuits 203, R-S latch circuits 204, and output logic circuits 205 are used.

Fig. 2 shows the structure of a latch circuit according to the first embodiment of the present invention. This latch circuit has four NOR circuits 71 to 74. The NOR circuits 71 and 72 constitute an R-S NOR latch circuit 201. One of two input terminals of the NOR circuit 73 is connected to an input terminal IN71. The other input terminal is connected to an input terminal IN72. The output terminal of the NOR circuit 73 is connected to the input terminal of the NOR circuit 71 corresponding to the set terminal of the R-S NOR latch circuit 201. The input terminal of the NOR circuit 72 corresponding to the reset terminal of the R-S NOR latch circuit 201 is connected to the input terminal IN72. The output terminal of the NOR circuit 72 corresponding to the negative output $\overline{Q}$ terminal of the R-S NOR latch circuit 201, and the input terminal IN72, are connected to the two input terminals of the NOR circuit 74. The output terminal of the NOR circuit 74 is connected to an output terminal OUT7.

This latch circuit operates in the following manner. While the input terminal IN72 is high level, a low level signal is outputted from the output terminal OUT7 irrespective of the level at the input terminal 71. A low level signal is also outputted from the output terminal OUT7 while the input terminal IN72 is low level and while the input terminal IN71 is low level.

A high level signal is outputted from the output terminal OUT7 in the following case. A high level signal is outputted from the output terminal OUT7 when the input terminal IN72 falls from the high level to the low level under the high level state at the input terminal 71. If the input terminal 72 rises to the high level or the input terminal 71 becomes low level, the level of the output terminal OUT7 becomes low level. The levels at the input terminals IN71 and IN72 and at the output terminal OUT7 are shown in the truth table of Fig. 7 and the timing chart of Fig. 11. "IN*1" and "IN*2" represent collectively for all input terminals IN71 to IN101 and IN72 to IN102 shown in Figs. 2 to 5.

The latch and reset operations of the latch circuit of this embodiment are performed in the following manner. In Fig. 11, the input terminal IN72 falls to the low level at time T11 to set an initial state. After this time instant, the level changed at the input terminal IN71 is monitored. While the input terminal IN71 is high level from time T11 to time T12, the output terminal OUT7 is high level. When the input terminal IN71 rises from the high level to the low level at time T12, the circuit enters the latch state and the output terminal OUT7 holds the low level state. This latch state is reset when the input terminal IN71 changes to the high level. The latch circuit has a function to hold a low level signal, unlike the conventional latch circuit shown in Fig. 12.

A latch circuit according to the second embodiment of the present invention is shown in Fig. 2. This latch circuit is obtained by replacing the NOR circuits 71 to 74 of the first embodiment with NAND circuits 81 to 84. The NAND circuits 81 and 82 constitute an R-S NAND latch circuit. The levels at input terminals IN81 and IN82 and at an output terminal OUT8 are opposite to the levels at the input terminals IN71 and IN72 and at the output terminal OUT7 of the first embodiment. This latch circuit of the second embodiment operates in the manner shown in the truth table of Fig. 8 and the timing chart of Fig. 11. Specifically, when the input terminal IN82 rises to the high level, the initial state is set. After this time instant, the level change at the input terminal IN81 is monitored. While the input terminal IN81 is low level, the output terminal OUT8 is low level. When the input terminal IN81 rises from the low level to the high level, the circuit enters the latch state and the output terminal OUT8 holds the high level state. This latch state is reset when the input terminal IN82 changes to the low level. This latch circuit has a function to hold a high level signal, similar to the conventional latch circuit shown in Fig. 12.

The third embodiment of the present invention has the structure shown in Fig. 4. The latch circuit of this embodiment has four NOR circuits 91 to 94. The NOR circuits 91 and 92 constitute an R-S NOR latch circuit 203. The fundamental structure is the same as that of the first embodiment. A different point resides in that although in the first embodiment the negative output $\overline{Q}$ terminal of the R-S NOR latch circuit 201 is connected to the input terminal of the NOR circuit 74, in the third embodiment the positive Q terminal of the R-S NOR latch circuit 203 is connected to the input terminal of the NOR circuit 94. The level changes at input terminals IN91 and IN92 and at output terminal OUT9 of this latch circuit are shown in the truth table of Fig. 9 and the timing chart of Fig. 11.

The latch and reset operations of the latch circuit of this embodiment are performed in the following manner. When the input terminal IN92 falls to the low level, the circuit enters the initial state, and the level change at the input terminal IN91 is monitored. While the input terminal IN91 is high level, the output terminal OUT9 is low level. When the input terminal IN91 falls to the low level, the output terminal OUT9 changes to the high level which is then latched. This latch state is reset when the input terminal IN92 becomes high level.

The structure of a latch circuit according to the fourth embodiment of the present invention is shown in Fig. 5. This latch circuit has four NAND circuits 101 to 104. The NAND circuits 101 and 102 constitute an R-S NAND latch circuit. The fundamental structure of the fourth embodiment is the same as the second embodiment. A different point resides in that although in the second embodiment the negative $\overline{Q}$ terminal of the R-S NAND latch circuit 202 is connected to the input terminal of the NAND circuit 84, in the fourth embodiment the positive Q terminal of the R-S NAND latch circuit 204 is connected to the input terminal of the NAND circuit 104. The level changes at input terminals IN101 and IN102 and at an output terminal OUT10 are shown in the truth table of Fig. 10 and the timing chart of Fig. 11, and are opposite to those of the Fig. 3 embodiment.

Specifically, when the input terminal IN102 rises to the high level, the initial state is set and the level change at the input terminal IN101 is monitored. While the input terminal IN101 is low level, the output terminal OUT10 is high level. When the input terminal IN101 rises to the high level, the output terminal OUT10 changes to the low level which is in turn latched. This latch state is reset when the input terminal IN102 becomes low level.

Fig. 5 shows the structure of a latch circuit according to the fifth embodiment of the present invention. This latch circuit has four NOR circuits 111 to 114. The NOR circuits 111 and 112 constitute an R-S NOR latch circuit 205. To one input terminal of the NOR circuit 113, a plurality of input terminals IN111 to IN1n1 (where n is an integer of 2 or greater) are commonly connected. To the other input terminal, an input terminal IN112 is connected. The output terminal of the NOR circuit 113 is connected to the input terminal of the NOR circuit 111 corresponding to the set terminal of the R-S NOR latch circuit 205. The input terminal of the NOR circuit 112 corresponding to the reset terminal of the R-S NOR latch circuit 205 is connected to the input terminal IN112. The output terminal of the NOR circuit 112 corresponding to the negative Q terminal of the R-S NOR latch circuit 205, and the output terminal of the NOR circuit 112, are connected to the two input terminals of the NOR circuit 114. The output terminal of the NOR circuit 114 is connected to an output terminal OUT11.

A different point of this latch circuit from the first embodiment is that there are provided a plurality of input terminals IN111 to IN1n1 which are connected to the one input terminal of the NAND circuit 113. Therefore, when the input terminal IN112 falls to the low level to enter the initial state and one of the input terminals IN111 to IN1n1 changes from the high level to the low level, this low level is latched at the output terminal OUT11. This latch state is reset when the input terminal IN112 becomes high level.

According to the first to fifth embodiments, even if the latch circuit of any one of the embodiments enters a latch state by an erroneous input signal such as noises, the latch circuit can be reset by changing the level at one of the input terminals IN72 to IN112, without turning off power.

Furthermore, in the conventional latch circuits shown in Figs. 13 to 17, in addition to an input signal to be latched, an additional input signal and hence new circuit elements are required, resulting in an increased number of circuit elements. In contrast, according to the above-described embodiments, a signal to be latched is supplied to the input terminals IN71 to IN101, and IN111 to IN1n1, and a signal which changes to a predetermined level for the latch operation and changes to another level for the reset operation, is supplied to the other input terminals IN72 to IN112. Accordingly, new circuit elements other than those in the circuits shown in Figs. 2 to 6 are not necessary, so that the function of the latch circuit of Fig. 12 can be obtained with a minimum number of circuit elements.

The above-described embodiments have been described by way of example only, and the present invention is not limited thereto. For example, the number of input terminals to which a signal to be latched may take any desired number, while ensuring the reliable latch and reset operations described above.

Reference signs in the claims are intended for better understanding and shall not limit the scope.

**Claims**

1. In a latch circuit for latching an inputted signal, said latch circuit comprising:

    a first input terminal (IN201) to which a first signal to be latched is inputted;

    a second input terminal (IN202) to which is inputted a second signal which controls an operation of latching said first signal or an operation of resetting a latch state;

    an input logic circuit (203) whose input terminals are connected to said first and second input terminals (IN201, IN202);

    an R-S latch circuit (204) whose one input terminal is connected to the output terminal of said input logic circuit (203) and whose other input terminal is connected to said second input terminal (IN202);

    an output logic circuit (205) whose input terminals are connected to one of two output terminals of said R-S latch circuit (204) and to said second input terminal (IN202); and

    an output terminal (OUT20) connected to the output terminal of said output logic circuit (205), for holding an output signal of a predetermined level during said latch state.

2. A latch circuit according to claim 1, wherein said input logic circuit is a two-input NOR circuit (73 or 93), said R-S latch circuit is an R-S NOR latch circuit (201 or 203), and said output logic circuit is a two-input NOR circuit (74 or 94).

3. A latch circuit according to claim 1, wherein said input logic circuit is a two-input NAND circuit (81 or 103), said R-S latch circuit is an R-S NAND latch circuit (202 or 204), and said output logic circuit is a two-input NAND circuit (84 or 104).

4. A latch circuit according to claim 1, wherein said first input terminal includes a plurality of input terminals (IN111 - IN1n1) to which a plurality of said first input signals are inputted, and said input logic circuit (113) has input terminals respectively connected to said plurality of first input terminals (IN111 - IN1n1) and said second input terminal (IN112).

FIG.1

EP 0 488 382 A2

FIG.2

FIG.3

FIG.4

FIG.5

FIG.6

| IN71 | IN72 | OUT 7 |
|:---:|:---:|:---:|
| ·X· | H | L |
| L | L | L |
| H ⟶ X· | ⌐_ | "H" UNTIL IN71 FALLS FROM "H" TO "L" AFTERWARD "L" |

# FIG. 7

| IN81 | IN82 | OUT 8 |
|:---:|:---:|:---:|
| ·X· | L | H |
| H | H | H |
| L ⟶ X· | _⌐ | "L" UNTIL IN81 RISES FROM "L" TO "H" AFTERWARD "H" |

# FIG. 8

| IN 91 | IN 92 | OUT 9 |
|:---:|:---:|:---:|
| ·X· | H | L |
| L | L | H |
| H ⟶ X· | ⌐_ | "L" UNTIL IN91 FALLS FROM "H" TO "L" AFTERWARD "H" |

# FIG. 9

| IN101 | IN102 | OUT 10 |
|:---:|:---:|:---:|
| ·X· | L | H |
| H | H | L |
| L ⟶ X· | _⌐ | "H" UNTIL IN101 RISES FROM "L" TO "H" AFTERWARD "L" |

# FIG.10

9

FIG. 11

EP 0 488 382 A2

FIG.12  PRIOR  ART

FIG.13  PRIOR  ART

FIG. 14  PRIOR  ART

FIG. 15  PRIOR  ART

FIG.16  PRIOR  ART

FIG.17  PRIOR  ART

11

| IN I | OUT I |
|------|-------|
| L | "L" UNTIL"H"IS INPUTTED |
| H | LATCHED TO "H" |

# FIG.18 PRIOR ART

| IN 21 | IN 22 | OUT21 | OUT 22 |
|-------|-------|-------|--------|
| L | L | Q | $\overline{Q}$ |
| L | H | H | L |
| H | L | L | H |
| H | H | L | L |

# FIG.19 PRIOR ART

| IN 31 | IN 32 | IN 33 | OUT 31 | OUT 32 |
|-------|-------|-------|--------|--------|
| L | L | L | L | L |
| L | H | L | L | H |
| H | L | L | H | L |
| H | H | L | Q | $\overline{Q}$ |
| ※ | ※ | H | Q | $\overline{Q}$ |

# FIG.20 PRIOR ART

| IN41 | IN42 | OUT41 | OUT42 |
|------|------|-------|-------|
| L | L | Q | $\overline{Q}$ |
| L | H | L | H |
| H | L | H | L |
| H | H | H | L |

# FIG.21 PRIOR ART

| IN5 | CL5 | OUT5 |
|-----|-----|------|
| L | H | L |
| H | H | H |
| IN5 | ⌐ᒧ | IN5 |

# FIG.22 PRIOR ART

| IN6 | CL6 | OUT6 |
|-----|-----|------|
| IN6 | ⌐ | IN6 |
| ·X· | ⌐ᒧ | Q |

# FIG.23 PRIOR ART

13

EP 0 488 382 A2

FIG.24  PRIOR ART

FIG. 26 PRIOR ART

FIG. 25  PRIOR ART